(19) **Europäisches Patentamt**
**European Patent Office**
**Office européen des brevets**

(11) **EP 1 598 683 B1**

(12) **FASCICULE DE BREVET EUROPEEN**

(45) Date de publication et mention
de la délivrance du brevet:
**30.05.2012 Bulletin 2012/22**

(51) Int Cl.:
*G02B 6/12* *(2006.01)*    *G02B 6/122* *(2006.01)*
*G02B 6/125* *(2006.01)*    *G02F 1/025* *(2006.01)*
*H01S 5/22* *(2006.01)*

(21) Numéro de dépôt: **05300377.8**

(22) Date de dépôt: **16.05.2005**

(54) **Procédé de réalisation d'un composant optoélectronique comprenant un guide d'onde courbé avec des flancs inclinés rentrants**

Herstellungsverfahren eines optoelektronischen Bauelements mit gekrümmetem Wellenleiter mit inversem Trapezquerschnitt

Process of manufacturing an optoelectronic device comprising a curved waveguide having an inversed mesa cross-section

(84) Etats contractants désignés:
**DE FR GB IT**

(30) Priorité: **17.05.2004 FR 0450972**

(43) Date de publication de la demande:
**23.11.2005 Bulletin 2005/47**

(73) Titulaire: **3S Photonics**
**91620 Nozay (FR)**

(72) Inventeurs:
• **Burie, Jean-René**
**91625, Nozay Cedex (FR)**
• **Glastre, Geneviève**
**91625, Nozay Cedex (FR)**

(74) Mandataire: **Feray, Valérie et al**
**Feray Lenne Conseil**
**Le Centralis**
**63, avenue du Général Leclerc**
**92340 Bourg-la-Reine (FR)**

(56) Documents cités:
**EP-A- 0 651 268        WO-A-01/17076**
**US-A- 5 300 463        US-A1- 2001 036 679**
**US-A1- 2002 132 385        US-A1- 2002 187 579**

• **PEARTON S J ET AL: "Comparison of plasma chemistries for patterning InP-based laser structures", PLASMA SOURCES SCIENCE AND TECHNOLOGY, INSTITUTE OF PHYSICS PUBLISHING, BRISTOL, GB LNKD- DOI: 10.1088/0963-0252/3/1/003, vol. 3, no. 1, 1 February 1994 (1994-02-01), pages 19-24, XP020070476, ISSN: 0963-0252**

Printed by Jouve, 75001 PARIS (FR)

## Description

La présente invention concerne un composant optoélectronique à semi-conducteur comprenant un guide d'onde sous forme d'un ruban courbé à plus de deux degrés avec des flancs inclinés de façon rentrante.

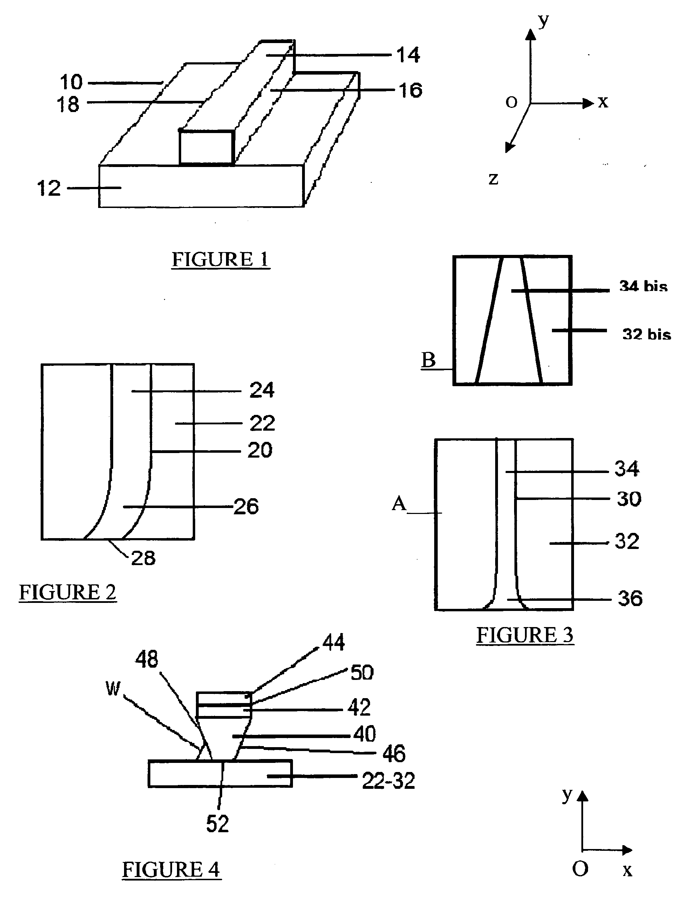

Le type de composant optoélectronique concerné par la présente invention est illustré sur la figure 1. Sur cette figure, le composant 10 comporte un substrat 12 et un guide d'onde 14 qui a la forme d'un ruban sensiblement parallélépipédique rectangle. Lorsque le composant est formé de l'association d'un laser et d'un modulateur, la longueur de ce ruban guide d'onde est typiquement de 600 microns et sa largeur de 2,5 microns. Le guide d'onde comporte des flancs latéraux 16 et 18. Le substrat et le guide d'onde sont formés par un empilement de couches de matériaux semiconducteurs. Les deux extrémités de l'empilement sont recouvertes d'une couche métallique assurant le contact électrique. Réduit à sa plus simple expression, l'empilement est formé d'une première couche (le substrat), d'une couche servant de confinement optique vertical (selon la direction Oy) pour les ondes se propageant dans le guide, d'une couche de confinement optique latéral (selon la direction Ox) et d'une couche de contact. Cette dernière couche est de faible épaisseur comparée à l'épaisseur de la couche de confinement optique latéral, cette dernière constituant en fait le conduit semi-conducteur dans lequel se propagent les ondes.

De manière classique, deux améliorations ont été apportées de manière séparée à ce composant. D'une part, la forme rectiligne du ruban guide a été courbée de façon à éviter les réflexions parasites des ondes sur la face de sortie du composant (et aussi éventuellement sur la face d'entrée). Cette courbure est obtenue par attaque chimique avec de l'acide chlorhydrique lors de la fabrication du composant. D'autre part, les flancs latéraux du ruban guide ont été inclinés, de façon rentrante, par rapport à la verticale du substrat afin de diminuer la résistance électrique du composant. De plus, pour ce même composant une très légère courbure du guide, au maximum de deux degrés, a été réalisée. L'inclinaison des flancs latéraux et la très légère courbure ont été obtenues par attaque chimique avec de l'acide bromhydrique. Ces caractéristiques seront développées par la suite dans l'exposé de l'invention.

Cependant, ces techniques ne permettent pas d'obtenir pour le même composant une courbure du ruban guide supérieure à deux degrés et une inclinaison des flancs latéraux. L'attaque chimique par l'acide chlorhydrique permet d'obtenir la courbure du guide mais pas l'inclinaison des flancs et l'attaque par l'acide bromhydrique permet d'obtenir l'inclinaison des flancs mais pas une courbure de guide d'onde dépassant deux degrés.

Les document US 2001/036679, WO 01/17076 et US 2002/187579 décrivent différents composants optoelectroriques.

La présente invention apporte une solution à ce problème technique en permettant d'obtenir sur le même composant optoélectronique un guide courbé à plus de deux degrés et des flancs inclinés rentrants.

De façon plus précise, l'invention a pour objet un composant optoélectronique à semi-conducteur avec guide d'onde sous forme d'un ruban supporté par un substrat, le ruban comprenant des flancs latéraux et une face de sortie de la lumière, caractérisé en ce que ledit ruban comporte au moins une partie courbée de plus de deux degrés par rapport à la perpendiculaire à la face de sortie de la lumière, et en ce que les flancs latéraux sont inclinés, de façon rentrante, sur ledit substrat.

Selon un mode de réalisation, la largeur dudit ruban, pour une même distance par rapport audit substrat, est sensiblement constante le long dudit ruban et peut, mais non nécessairement, se terminer à la sortie du guide d'onde par une forme évasée.

Selon un autre mode de réalisation, ladite partie courbée a une forme évasée à la sortie du guide d'onde.

Le composant optoélectronique peut être par exemple l'un ou l'autre des dispositifs suivants : un modulateur électro-optique, un amplificateur optique à semi-conducteur, un laser à semi-conducteur et un interféromètre du type Mach-Zehnder. Le composant peut également être formé par l'association de deux de ces dispositifs, par exemple un laser suivi d'un modulateur électro-optique.

L'invention concerne aussi un procédé de réalisation dudit ruban du composant optoélectronique, le procédé étant caractérisé en ce que l'on utilise de l'acide iodhydrique pour réaliser lesdits flancs latéraux inclinés.

Selon une forme de mise en oeuvre du procédé, ledit ruban est supporté par un substrat et est formé d'un empilement de couches comprenant au moins, en partant dudit substrat, une couche de confinement optique vertical comportant de l'arsenic, une couche de confinement optique latéral ne comportant pas d'arsenic et une couche de contact comportant de l'arsenic, le procédé étant caractérisé en ce que :

- un masque de résine est déposé par photolithographie sur ladite couche de contact, ledit masque de résine matérialisant le tracé dudit ruban,
- la partie de ladite couche de contact non située sous ladite couche de résine est enlevée par décapage ionique,
- ladite couche de confinement optique latéral est gravée chimiquement à l'aide d'une solution d'acide iodhydrique, et
- ledit masque de résine est enlevé.

La solution d'acide iodhydrique est de préférence de l'acide iodhydrique pur.

D'autres avantages et caractéristiques de l'invention apparaîtront au cours de la description qui suit de plusieurs modes de réalisation, donnés à titre d'exemples non limitatifs, en référence aux dessins annexés et sur lesquels :

- la figure 1 représente de façon schématique l'architecture générale des composants concernés par l'invention,
- la figure 2 est une vue de dessus d'un exemple de réalisation du composant,
- la figure 3 est une vue de dessus de deux autres exemples de réalisation du composant,
- la figure 4 est une coupe selon un plan xOy des composants des figures 2 et 3,
- les figures 5 à 7 illustrent le procédé de réalisation du composant.

La figure 2 représente schématiquement une vue de dessus, selon l'axe Oy, d'un mode de réalisation de l'invention et qui concerne la première amélioration mentionnée plus haut, à savoir la courbure du guide d'onde. Sur cette figure, le guide d'onde 20, supporté par le substrat 22, comporte une partie droite 24 suivie d'une partie courbée 26 dirigée vers la sortie 28 du guide, laquelle constitue la face de sortie de la lumière. Les flancs du ruban guide 20 sont inclinés, de façon rentrante, par rapport à la verticale (la surface du substrat est dans le plan zOx et la verticale est donc selon l'axe Oy). La largeur dudit ruban (20), pour une même distance verticale (selon l'axe Oy) par rapport audit substrat (22), est sensiblement constante le long dudit ruban. En d'autres termes, les deux bords supérieurs du guide d'onde sont sensiblement parallèles entres eux comme représenté sur la figure 2.

La partie courbée 26 permet de diminuer, ou même de supprimer, les ondes réfléchies par la face de sortie 28 et d'éviter ainsi des perturbations nées d'un couplage dans le composant des ondes réfléchies avec les ondes se propageant vers la sortie (dans la direction Oz). Lorsque le composant est un amplificateur optique à semi-conducteur, il est intéressant de courber le guide à ses deux extrémités de façon à éliminer les perturbations dues aux ondes réfléchies aux deux extrémités.

La figure 3 A montre une autre forme de réalisation, en vue de dessus, d'un guide courbé. Le ruban guide 30, supporté par le substrat 32, comporte une partie droite 34 suivie d'une partie courbée 36 mais ici de forme évasée. Dans la seconde réalisation montrée en vue de dessus sur la figure 3B il n'y a pas de partie droite. Le ruban guide 34 bis, supporté par le substrat 32 bis, ne comportent que des flancs latéraux qui divergent l'un par rapport à l'autre (en vue de dessus).

Selon l'art antérieur, la courbure du guide d'onde est réalisée principalement par décapage chimique avec de l'acide chlorhydrique. Selon l'invention, on utilise de l'acide iodhydrique.

La seconde amélioration mentionnée plus haut, illustrée sur la figure 4, consiste à donner une inclinaison rentrante aux flancs latéraux du guide. Sur la figure 4, qui est une coupe du composant optoélectronique de la figure 2 ou 3, selon un plan xOy, le ruban guide, supporté par le substrat 22 (figure 2) ou 32 (figure 3), est formé par l'empilement d'une couche 40 de confinement optique latéral, d'une couche de contact 42 et d'une couche métallique 44 pour le contact électrique. Le dessin n'est pas à l'échelle, l'épaisseur de l'ensemble formé par les deux couches 42 et 44 étant très faible (de l'ordre de 0.3 $\mu$m) comparée à l'épaisseur de la couche 40 (de l'ordre de 3 $\mu$m). Les flancs latéraux 46 et 48 forment un angle rentrant w dans le plan xOy. Cette inclinaison a pour but de diminuer la résistance électrique du composant qui est due principalement à la résistance électrique de l'interface 50 entre la couche métallique 44 et la couche de contact 42. Cette résistance électrique R est égale à :

$$R = ? \, l / S$$

? étant la résistivité, l la longueur et S la surface de l'interface. En augmentant la surface S, on diminue donc la résistance électrique R.

La diminution de la résistance R permet de diminuer la consommation électrique et l'échauffement du composant. Elle permet également d'augmenter la bande passante. Cependant, pour des considérations de guidage optique des ondes, la largeur 52 à la base du guide ne peut pas dépasser une certaine valeur. Cette largeur est de l'ordre de quelques microns, par exemple 2,5 microns. On a donc deux impératifs qui s'opposent: d'une part, obtenir une résistance électrique R la plus faible possible en augmentant la surface S et, d'autre part, ne pas dépasser certaines valeurs pour la largeur 52 à la base du guide d'onde. L'inclinaison des flancs latéraux 46 et 48 apporte un bon compromis à ces deux impératifs contradictoires.

Selon l'art antérieur, l'inclinaison des flancs latéraux est obtenue par attaque chimique à l'aide d'acide bromhydrique. L'attaque par l'acide bromhydrique permet également d'obtenir une très légère courbure du ruban guide ne dépassant pas deux degrés. Au-delà de cette valeur, se produit une attaque sévère des flancs qui détruit l'inclinaison recherchée et qui rend le composant inutilisable. Selon l'invention, l'inclinaison des flancs est obtenue par attaque chimique avec de l'acide iodhydrique. L'utilisation de cet acide permet donc d'obtenir à la fois la courbure du guide d'onde, avec une courbure supérieure à deux degrés, et l'inclinaison des flancs latéraux, ce que ne permet pas l'art antérieur.

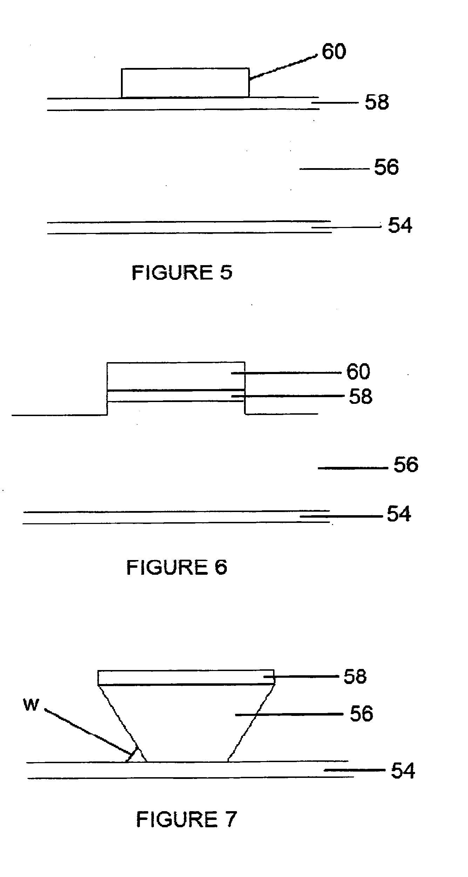

Les figures 5 à 7 illustrent le procédé de réalisation de la courbure du guide d'onde et de l'inclinaison des flancs latéraux. Sur ces figures n'ont été représentées que les couches nécessaires à la compréhension du procédé. Par exemple, les couches métalliques de contact ne figurent pas. Le composant comprend successivement une couche 54, une couche de confinement optique latérale 56 et une couche de contact 58. La couche 54 est de préférence constituée par un matériau quaternaire tel que GaInAsP, alors que la couche de contact 58 est constituée de préférence par un matériau tertiaire tel que GaInAs. La couche 56 de confinement optique latérale est de préférence formée par InP dopé p. On remarque que les couches 54 et 58 comportent de l'arsenic, élément qui bloque une attaque chimique par l'acide iodhydrique, alors que la couche 56 n'en contient pas Un masque de résine 60 est déposé par photolithographie sur la couche de contact 58, en matérialisant le tracé du guide d'onde. Ce masque de résine a donc la forme, vue de dessus, que l'on veut donner au guide d'onde. Cette forme comprend au moins une partie faisant un angle avec la normale à la facette de sortie, comme représentée par exemple sur la figure 2 ou 3.

L'étape suivante du procédé (figure 6) consiste en un décapage ionique de la couche de contact 58. Les parties de cette couche non situées en dessous du masque de résine, donc non protégées, sont enlevées. Si une couche métallique de contact électrique, en platine par exemple, était interposée entre le masque de résine et la couche de contact, les parties non protégées de cette couche métallique seraient également enlevées.

Le composant est ensuite trempé dans une solution d'acide iodhydrique afin de former l'inclinaison rentrante des flancs latéraux du guide d'onde (figure 7). De préférence, la solution est de l'acide iodhydrique pur. Cet acide n'attaque que la couche InP 56, la présence d'arsenic dans les couches 54 et 58 bloquant l'attaque chimique. Ce traitement par l'acide iodhydrique pur est de l'ordre de la minute, quelques minutes tout au plus. L'angle d'inclinaison w des flancs rentrants est déterminé par l'orientation du plan cristallin du matériau monocristallin InP. Cet angle est d'environ 54 degrés lorsque le plan cristallin est parallèle au plan yOz. Dans la partie courbée du guide d'onde, le plan cristallin révélé par l'attaque par l'acide iodhydrique n'est plus le même; il s'ensuit que l'angle d'inclinaison w augmente avec l'angle de courbure. Les flancs sont donc plus rentrants dans la ou les parties courbe(s) du guide.

L'invention permet donc de réaliser un composant optoélectronique qui comporte à la fois des flancs inclinés rentrants et au moins une partie courbée avec un angle supérieur à deux degrés. Ce composant peut être un modulateur électro-optique, un amplificateur optique à semi-conducteur, un laser à semi-conducteur ou un interféromètre du type Mach-Zehnder. Il peut aussi être constitué de l'association de deux de ces dispositifs, par exemple un laser à semi-conducteur suivi d'un modulateur électro-optique.

Les exemples de réalisation décrits montrent un composant ayant une partie droite de guide d'onde suivie d'une partie courbée. La forme du guide d'onde peut être plus complexe. Par exemple, dans le cas d'un amplificateur optique à semi-conducteur, les deux extrémités du guide sont avantageusement courbées de façon à éviter les réflexions sur ces deux faces. Le guide comprend alors successivement une partie courbée, une partie droite et une partie courbée ou un guide droit avec une forte inclinaison par rapport aux faces de sorties (typiquement 7° à 10°).

## Revendications

1. Procédé de réalisation du ruban d'un composant optoélectronique à semi-conducteur avec guide d'onde sous forme d'un ruban (20,30) supporté par un substrat (22,32), le ruban (20,30) comprenant une face de sortie de la lumière, des flancs latéraux (46,48) inclinés de façon rentrante sur ledit substrat (22,32) et une partie courbée (26,36) par rapport à la normale à la face de sortie de la lumière, ledit ruban (20,30) étant supporté par un substrat (54) comportant de l'arsenic, ledit ruban (20,30) formant un empilement de couches comprenant au moins, en partant dudit substrat (54), une couche de confinement optique latérale (56) formée d'InP et ne comportant pas d'arsenic et une couche de contact (58) comportant de l'arsenic, **caractérisé en ce que** :

    - un masque de résine (60) est déposé par photolithographie sur ladite couche de contact (58), ledit masque de résine (60) matérialisant le tracé dudit ruban (20,30),
    - la partie de ladite couche de contact (58) non située sous ladite couche de résine est enlevée par décapage ionique,
    - ladite couche de confinement optique latérale (56) est gravée chimiquement à l'aide d'une solution d'acide iodhydrique, et
    - ledit masque de résine (60) est enlevé.

2. Procédé selon la revendication 1, **caractérisé en ce que** ladite solution d'acide iodhydrique est de l'acide iodhydrique pur.

3. Procédé selon la revendication 1 ou 2, **caractérisé en ce que** ladite couche de contact (58) est formée de GaInAs et ledit substrat (54) est formé de GaInAsP.

## Claims

1. A method for making the strip of an opto-electronic semiconductor component with a waveguide in the form of a strip (20, 30) supported by a substrate (22, 32), the strip (20, 30) comprising a light output face, inwardly tilted side flanks (46, 48) on said substrate (22, 32) and a curved portion (26, 36) are relatively to the normal to the light output face, said strip (20, 30) are being supported by a substrate (54) including arsenic, are said strip (20, 30) forming a stack of layers, at least comprising, from said substrate (54), one side confinement layer (56) formed with InP and not including arsenic and one contact layer (58) including arsenic, **characterized in that**:

    - a resin mask (60) is deposited by photolithography on said contact layer (58), said resin mask (60) materializing the course of said strip (20, 30),
- the portion of said contact layer (58) not located under said resin layer is removed by ion stripping,
- said side optical confinement layer (56) is chemically etched with a solution of hydroiodic acid, and
- said resin mask (60) is removed.

2. The method according to claim 1, **characterized in that** said hydroiodic acid solution is pure hydroiodic acid.

3. The method according to claim 1 or 2, **characterized in that** said contact layer (58) is formed with GaInAs and said substrate (54) is formed with GaInAsP.

## Patentansprüche

1. Verfahren zur Herstellung des Streifens eines optoelektronischen Halbleiterbauteils mit Wellenleiter in Form eines Streifens (20, 30), der von einem Substrat (22, 32) getragen wird, wobei der Streifen (20, 30) eine Lichtausgangsseite, Seitenflächen (46, 48), die auf dem Substrat (22, 32) zusammenlaufend geneigt sind und einen auf der Lichtausgangsseite im Verhältnis zur Normalen gekrümmten Abschnitt (26, 36) umfasst, wobei der Streifen (20, 30) von einem Substrat (54) getragen wird, das Arsen aufweist, wobei der Streifen (20, 30) einen Stapel von Schichten bildet, der mindestens vom Substrat (54) ausgehend eine seitliche optische Einschlussschicht (56) umfasst, die von InP gebildet wird und kein Arsen aufweist und einen Kontaktschicht (58), die Arsen aufweist, **dadurch gekennzeichnet, dass**:

- eine Harzmaske (60) durch Fotolitographie auf die Kontaktschicht (58) aufgebracht ist, wobei die Harzmaske (60) den Verlauf des Streifens (20, 30) materialisiert,
- der Abschnitt der Kontaktschicht (58), der sich nicht unter der Harzschicht befindet, durch Ionenbeizen entfernt wird,
- die seitliche optische Einschlussschicht (56) chemisch mit Hilfe einer Iodwasserstoffsäurelösung graviert wird, und
- die Harzmaske (60) entfernt wird.

2. Verfahren nach Anspruch 1, **dadurch gekennzeichnet, dass** die Iodwasserstoffsäurelösung reine Iodwasserstoffsäure ist.

3. Verfahren nach Anspruch 1 oder 2, **dadurch gekennzeichnet, dass** die Kontaktschicht (58) von GaInAS gebildet wird und das Substrat (54) von GaInAsP gebildet wird.

10
18
14
16
12

y
O x
z

FIGURE 1

34 bis
32 bis
B

24
22
20
26
28

A
34
30
32
36

FIGURE 2

FIGURE 3

44
48
50
W
42
40
46
22-32
52

FIGURE 4

y
O x

60
58
56
54

FIGURE 5

60
58
56
54

FIGURE 6

58
W
56
54

FIGURE 7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2001036679 A
- WO 0117076 A
- US 2002187579 A